(19) Europäisches Patentamt
European Patent Office
Office européen des brevets

(11) **EP 1 091 423 A2**

(12) **EUROPÄISCHE PATENTANMELDUNG**

(43) Veröffentlichungstag:
**11.04.2001 Patentblatt 2001/15**

(51) Int. Cl.[7]: **H01L 41/053**, H01L 41/083

(21) Anmeldenummer: **00121881.7**

(22) Anmeldetag: **06.10.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **08.10.1999 DE 19948617**

(71) Anmelder:
**SIEMENS AKTIENGESELLSCHAFT**
**80333 München (DE)**

(72) Erfinder:
**Riedel, Michael, Dipl.-Phys.**
**96472 Roedental (DE)**

(54) **Vorrichtung zum Betätigen eines Stellgliedes**

(57)  Eine Vorrichtung (1,30) zum Betätigen eines Stellglieds (5) weist ein aktives Aktorelement (2) und ein passives Aktorelement (3) auf, die nebeneinander angeordnet sind, die durch Vorspannmittel (12) gemeinsam vorgespannt sind, und die mit einem Übertragungselement (4), welches für eine Wirkverbindung mit dem Stellglied (5) ausgebildet ist, kraftschlüssig verbunden sind. Erfindungsgemäß umfaßt das aktive und das passive Aktorelement (2,3) jeweils ein piezokeramisches Material (PI, PA), wobei das piezokeramische Material (PI) des passiven Aktorelements (3) inaktiv ist. Beide Aktorelemente (2,3) lassen sich durch das gleiche Herstellungsverfahren herstellen, was die Herstellungskosten senkt.

FIG 2

**EP 1 091 423 A2**

Printed by Xerox (UK) Business Services
2.16.7 (HRS)/3.6

**Beschreibung**

Die Erfindung betrifft eine Vorrichtung zum Betätigen eines Stellgliedes, mit einem aktiven Aktorelement und einem passiven Aktorelement, die nebeneinander angeordnet sind, die durch Vorspannmittel gemeinsam vorgespannt sind, und die mit einem Übertragungselement, welches für eine Wirkverbindung mit dem Stellglied ausgebildet ist, kraftschlüssig verbunden sind. Eine derartige Vorrichtung ist beispielsweise aus der am 15.12.1998 eingereichten deutschen Patentanmeldung mit dem amtlichen Aktenzeichen 198 57 922.5 bekannt. Die Vorrichtung eignet sich insbesondere zur Ansteuerung eines Kraftstoffeinspritzventils.

Aus der US 4,101,076 A ist eine Vorrichtung zum Betätigen eines Stellglieds bekannt, die einen piezoelektrischen Aktor aufweist, der über ein mechanisches Übertragungselement direkt eine Einspritznadel eines Kraftstoffeinspritzventils steuert. Das Übertragungselement weist zwei unterschiedlich lange Hebelarme auf, die im rechten Winkel zueinander angeordnet sind und in einem Auflagebereich miteinander verbunden sind. Der kürzere Hebelarm ist mit dem piezoelektrischen Aktor verbunden; der längere Hebelarm ist der Einspritznadel zugeordnet.

Die Vorrichtung gemäß der US 4,101,076 A bietet nur eine mäßige Steifigkeit, die insbesondere bei hochdynamischen Schaltvorgängen zu einer ungenauen Übertragung der Auslenkung auf die Einspritznadel und damit nachteiligerweise zu einer Fehlfunktion des Ventils führen kann.

Dieses Problem wird durch die eingangs genannte Vorrichtung gemäß der deutschen Patentanmeldung mit dem amtlichen Aktenzeichen 198 57 922.5 durch Verwendung eines aktiven und eines passiven Aktorelements gelöst. Jedoch ist für das zusätzliche passive Aktorelement auch ein zusätzlicher Arbeitsschritt erforderlich. Dies verteuert die Produktion und erhöht den Stückpreis, was bei Massenproduktion nachteiligerweise die Konkurrenzfähigkeit des Produktes schmälert.

Aufgabe der Erfindung ist es, eine Vorrichtung der eingangs genannten Art anzugeben, die sich günstig herstellen läßt und die ebenfalls die Nachteile der in der US 4,101,076 beschriebenen Vorrichtung vermeidet.

Diese Aufgabe wird für die Vorrichtung der eingangs genannten Art erfindungsgemäß dadurch gelöst, daß das aktive und das passive Aktorelement jeweils piezokeramisches Material umfassen, wobei das piezokeramische Material des passiven Aktors inaktiv ist.

Dabei bezeichnet ein piezokeramisches Material sowohl ein keramisches Material, welches piezoelektrisch aktiv ist, als auch ein solches keramisches Material, welches erst durch Polarisation oder eine sonstige Vorbehandlung piezoelektrisch aktiv wird.

Da beide Aktorelemente piezokeramisches Material aufweisen, können beide Aktorelemente auf gleiche Art und Weise hergestellt werden. Gegenüber dem Stand der Technik entfällt somit der separate Herstellungsprozeß für das passive Aktorelement. Dies reduziert die Herstellungskosten.

Eine Piezokeramik wird durch Polarisation in einem homogenen elektrischen Feld piezoelektrisch aktiv. Das passive Aktorelement kann eine unpolarisierte und damit eine inaktive Piezokeramik aufweisen. Ebenso ist es jedoch möglich, die Piezokeramik des passiven Aktorelements von der Versorgungsspannung abzukoppeln, so daß die Piezokeramik ebenfalls inaktiv bleibt. Von Vorteil ist es jedoch, die Piezokeramik des passiven Aktorelements unpolarisiert zu lassen. Eine unpolarisierte Piezokeramik weist andere Materialeigenschaften auf als eine polarisierte Piezokeramik. Dieser Unterschied läßt sich in vorteilhafter Weise - wie später angegeben wird - zur Verbesserung des Eigenschaftsspektrums der Vorrichtung ausnutzten.

Eine besonders gute Umsetzung der elektrischen Energie in mechanische Energie läßt sich erzielen, wenn die Aktorelemente jeweils aus einzelnen piezokeramischen Schichten in Form eines sogenannten "Stacks" aufgebaut sind, wobei zwischen benachbarten piezokeramischen Schichten jeweils eine Elektrode eingelegt ist. Aufgrund der dünnen piezokeramischen Schichten und des damit verbundenen geringen Abstands zwischen zwei benachbarten Elektroden wird eine hohe Kapazität C erzielt, so daß sich gemäß $E = 1/2\,C\,U^2$ bei gleicher Versorgungsspannung U eine höhere Energie E einspeisen läßt als bei einer einzelnen Piezokeramik, deren Dicke der Summe der Dikken der piezokeramischen Schichten entspricht. Bis auf den Polarisationsvorgang wird das passive Aktorelement exakt in gleicher Weise hergestellt wie das aktive Aktorelement.

Die beiden Aktorelemente können separat als zwei getrennte "Stacks" aufgebaut sein. Von Vorteil ist es jedoch, wenn beide Aktorelemente in einem gemeinsamen Stapel oder Stack aus piezokeramischen Schichten zusammengefaßt ist. Beide Aktorelemente können dann gemeinsam und gleichzeitig in einem einzigen Arbeitsschritt hergestellt werden, was zusätzlich Herstellungskosten reduziert. Vorteilhafterweise sind die Elektroden jeweils übereinander angeordnet, erstrecken sich jedoch jeweils nur über einen Teil der Querschnittsfläche des gemeinsamen Stapels. Der nicht von den Elektroden bedeckte Teil des Stapels bildet dann das passive Aktorelement. Wird die Piezokeramik des Stapels mittels der Elektroden polarisiert, so bleibt bei dieser Anordnung die Piezokeramik des passiven Aktorelements unpolarisiert und damit inaktiv, da am Ort des passiven Aktorelements kein elektrisches Feld aufgebaut werden kann, und infolgedessen keine Polarisation auftritt.

In einer weiteren vorteilhaften Ausgestaltung der Erfindung ist das aktive und das passive Aktorelement jeweils quaderförmig. Diese Form kann in einfacher Art und Weise hergestellt werden.

Weiter von Vorteil für die Erfindung ist es, wenn die zum Einspeisen der Versorgungsspannung notwendigen Kontaktierungsmittel, z.B. Kontaktierflächen aus einem aufgedampften Metall wie Silber oder aus einem aufgeklebten leitfähigen Kunststoff wie einem Graphit-haltigen Elastomer, an den Seitenflächen des aktiven Aktorelements unmittelbar dem passiven Aktorelement benachbart angeordnet sind. Damit sind die Kontaktiermittel in der Nähe der neutralen Zone der Vorrichtung angeordnet. Die mechanische Beanspruchung der Kontaktiermittel während der Ausdehnung des aktiven Aktorelements wird reduziert.

Vorteilhafterweise sind das aktive Aktorelement und das passive Aktorelement in einem gemeinsamen Gehäuse angeordnet, wobei eine Platte beiden Aktorelementen aufliegt und über die Vorspannmittel mit dem Gehäuse verbunden ist. Dabei sind die Vorspannmittel im Bereich der Grenzfläche zwischen aktivem und passivem Aktorelement angeordnet, so daß keine starke mechanische Beanspruchung der Vorspannmittel zu erwarten ist.

In einer weiteren vorteilhaften Ausgestaltung der Erfindung weist das Übertragungselement zwei Hebelarme auf, wobei der erste Hebelarm kraftschlüssig mit der Platte verbunden ist, und wobei der zweite Hebelarm für eine Wirkverbindung mit dem Stellglied ausgebildet ist. Dabei kann der erste Hebelarm mit der Platte verschraubt, verklebt oder in sonstiger Weise verbunden sein. Auch kann der erste Hebelarm als ein Teil der Platte selbst ausgebildet sein. Über das Längenverhältnis der Hebelarme läßt sich der Stellweg des Stellglieds einstellen.

Weiter von Vorteil ist es, wenn der erste und der zweite Hebelarm zueinander schwenkbar gelagert sind. Damit lassen sich seitliche Bewegungen des zweiten Hebelarms am Ort des Stellglieds, die aus der Verkippung des ersten Hebelarms resultieren, verhindern.

Falls die Piezokeramik des passiven Aktorelements unpolarisiert ist, zeigt sie insbesondere einen anderen thermischen Ausdehnungskoeffizienten als die polarisierte Piezokeramik gleicher Zusammensetzung. Dies läßt sich nun in vorteilhafter Weise zur Kompensation der Wärmeausdehnung der Vorrichtung ausnutzen. Insbesondere bei Aktoren mit geringem Nutzhub ist nämlich die Längenausdehnung der Piezokeramik störend, da sie in derselben Größenordnung liegt wie der Nutzhub (Typische Stacks weisen bei einer Bauhöhe von 10 bis 100 mm einen Nutzhub von 1 bis 1.5 ‰ der Bauhöhe auf). Eine Temperaturänderung führt daher zu einer Eigenverbiegung der Vorrichtung und damit zu einer ungewollten Lageveränderung des Stellglieds. Eine solche Lageveränderung kann jedoch, z.B. bei Ventilen, zu einem vollständigen Funktionsausfall führen. Das Ventil öffnet oder schließt sich ungewollt.

Bei der oben angegebenen Hebelanordnung kann nun jedoch das Verhältnis der thermischen Ausdehnungskoeffizienten des passiven und des aktiven Aktorelements oder der Abstand des passiven Aktorelements vom aktiven Aktorelement nach den Hebelgesetzen derart eingestellt werden, daß das Stellglied unabhängig von der Temperatur in einer vorgegebene Position verbleibt. Dies ist dann der Fall, wenn das Verhältnis der thermischen Ausdehnungskoeffizienten oder die Lage des passiven Aktorelements so eingestellt ist, daß die Platte bei Temperaturänderung infolge der unterschiedlichen Längenausdehnung des passiven und des aktiven Aktorelements exakt soweit verkippt wird, daß die Lageveränderung des Verbindungspunkts des ersten Hebelarms mit dem zweiten Hebelarm der Längenveränderung des zweiten Hebelarmes folgt.

In vorteilhafter Weise wird das Verhältnis der thermischen Ausdehnungskoeffizienten über das Verhältnis der Volumina des aktiven und des passiven Aktorelements eingestellt.

Ausführungsbeispiele der Erfindung werden anhand einer Zeichnung näher erläutert. Dabei zeigt:

FIG 1      in einem Längsschnitt eine erste Vorrichtung zur Betätigung eines Stellglieds mit einem passiven und einem aktiven Aktorelement;

FIG 2      die Vorrichtung gemäß FIG 1 bei einer höheren Temperatur;

FIG 3      in einem Querschnitt die Vorrichtung gemäß FIG 1;

FIG 4      in einem Längsschnitt eine Ausführungsform des aktiven und des passiven Aktorelements als gemeinsamer Stapel, und

FIG 5      in einem Längsschnitt eine zweite Vorrichtung zur Betätigung eines Stellglieds mit einem passiven und einem aktiven Aktorelement.

Gleiche Elemente werden dabei mit gleichen Bezugzeichen bezeichnet.

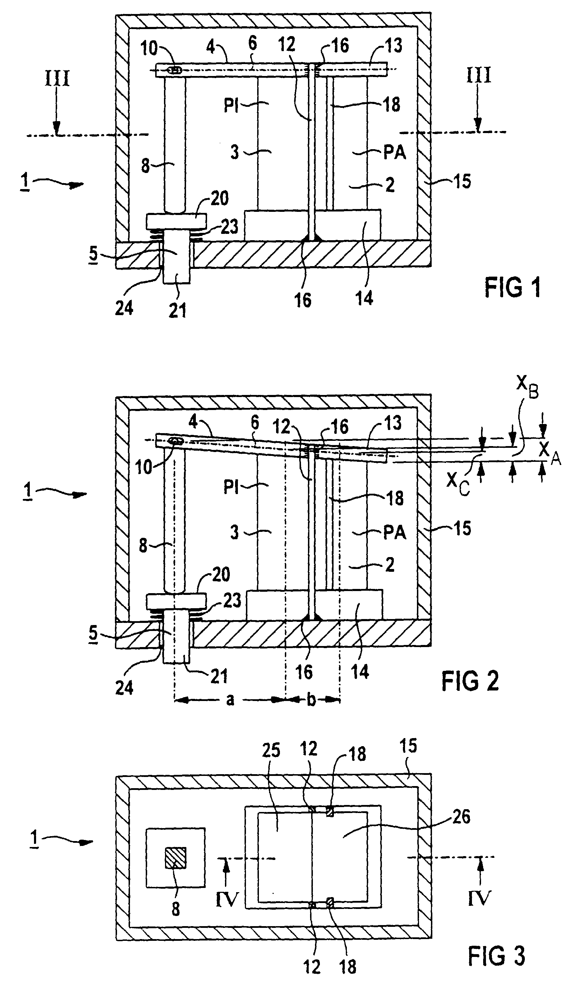

In Figur 1 ist eine erste Vorrichtung 1 zur Betätigung eines Stellglieds 5 mittels eines aktiven und eines passiven Aktorelements 2 bzw. 3 gezeigt. Die Bewegung der beiden Aktorelemente 2 und 3 wird mittels eines Übertragungselements 4 auf das Stellglied 5 übertragen. Das Übertragungselement 5 umfaßt hierzu einen ersten Hebelarm 6 und einen zweiten Hebelarm 8, die über ein Lager 10 im wesentlichen senkrecht miteinander verbunden sind. Über das Lager 10 kann der erste Hebelarm 6 gegenüber dem zweiten Hebelarm 8 in der Bildebene geschwenkt werden. Der zweite Hebelarm 8 ist - in Figur 1 nicht dargestellt - durch Führungsmittel in seiner senkrechten Position geführt.

Die beiden Aktorelemente 2 und 3 sind über Vorspannmittel 12 und über eine erste und eine zweite Platte 13 bzw. 14 auf Druck vorgespannt. Die Vorspannmittel 12 sind dabei als Zuganker ausgebildet und mittels Schweißnähten 16 mit den Platten 13 und 14 fest verbunden. Die Vorspannmittel 12 sind dabei an der Grenzfläche zwischen aktivem und passivem Aktorelement 2 bzw. 3 angeordnet. Die Stirnenden der beiden Aktoren 2 und 3 liegen dabei plan an den Flächen der Platten 13, 14 an, um eine gute Kraftübertragung, kleine Reaktionszeiten und geringe Scherkräfte zu erzielen. Der erste Hebelarm 6 ist gleichzeitig Bestandteil der ersten Platte 13 und überträgt die Auslenkung des aktiven und des passiven Aktorelements 2 bzw. 3 auf den zweiten Hebelarm 8, der auf das Stellglied 5 wirkt.

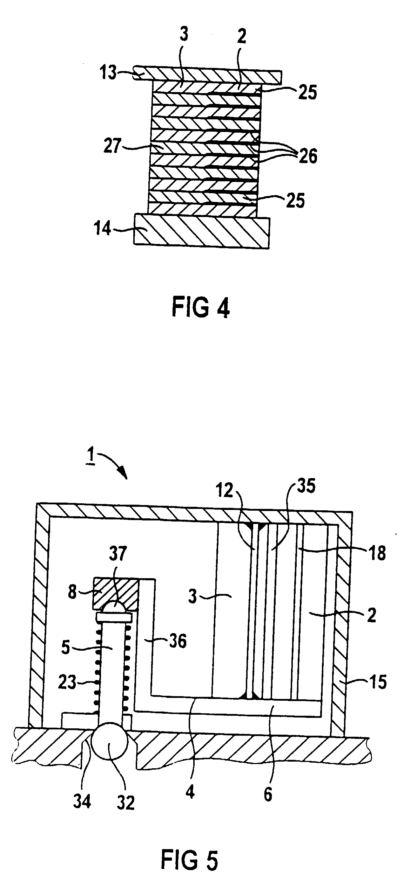

Das aktive und das passive Aktorelement 2 bzw. 3 sind beide Bestandteile eines gemeinsamen piezoelektrischen Stapels, der eine Anzahl von Schichten aus Piezokeramik mit jeweils zwischen den Schichten angeordneten Elektroden umfaßt. Die Elektroden sind dabei - wie in Figur 4 dargestellt - lediglich auf der Seite des aktiven Aktorelements 2 eingelegt, so daß nur das aktive Aktorelement 2 ansteuerbar ist. Das piezokeramische Material PA des aktiven Aktorelements 2 ist demnach aktiv. Die Polarisierung und damit die Aktivierung der Piezokeramik des gemeinsamen Stapels geschieht durch Anlegen einer vorgegebenen Spannung an die eingelegten Elektroden. Entsprechend dem Aufbau des gemeinsamen Stapels entsteht beim Polarisierungsvorgang an Stelle des passiven Aktorelements 3 kein elektrisches Feld. Das piezokeramische Material PI des passiven Aktorelements 3 bleibt demnach inaktiv.

Zur Ansteuerung des aktiven Aktorelements 2 sind an den Seitenflächen des aktiven Aktorelements 2 Kontaktierungsmittel 18 angeordnet. Die Kontaktierungsmittel 18 sind dabei als flächige Elektroden in Form eines Streifens aus aufgedampften Metall z.B. Silber ausgebildet. Die Elektroden sind in unmittelbarer Nähe zum passiven Aktorelement 3 angeordnet.

Die beiden Aktorelemente 2 und 3 sind über die zweite Platte 14 fest mit einem Gehäuse 15 verbunden, in dessen Wandung das Stellglied 5 geführt ist. Das Stellglied 5 weist einen Kopf 20 auf, mit dem das Ende des zweiten Hebelarms 8 wechselwirkt. Der Kopf 20 ist mittels eines Stiels 21 und einer den Stiel 21 umgebenden Feder 23 gegen das Gehäuse 15 gespannt, so daß das Stellglied 5 gegen das Ende des zweiten Hebelarms 8 gedrückt wird.

Wird mittels der Kontaktierungsmittel 18 eine Steuerspannung an das aktive Aktorelement 2 angelegt, so verdicken sich die einzelnen piezokeramischen Schichten. Entsprechend vergrößert sich der Abstand zwischen den beiden Platten 13 und 14. Da das inaktive Aktorelement 3 keine Längenänderung erfährt, wird die erste Platte 13 verkippt und drückt den zweiten Hebelarm 8 gegen den Kopf 20 des Stellglieds 5. Das Stellglied 5 wird gegen das Gehäuse 15 verschoben. Diese Verschiebung kann zum Schließen oder Öffnen eines Ventils wie beispielsweise einem Kraftstoffeinspritzventil verwendet werden.

In Figur 2 ist die Vorrichtung 1 gemäß Figur 1 bei einer höheren Temperatur dargestellt. Aufgrund der höheren Temperatur zeigen - einen positiven thermischen Ausdehnungskoeffizienten vorausgesetzt - der zweite Hebelarm 8, das aktive Aktorelement 2 und das passive Aktorelement 3 eine Längenausdehnung in der Zeichenebene. Die Zeichnung ist für den Fall dargestellt, daß der zweite Hebelarm 8 einen größeren thermischen Ausdehnungskoeffizienten zeigt als das aktive Aktorelement 2. Infolgedessen führt eine Temperaturerhöhung zu der dargestellten Verkippung der ersten Platte 13 und damit des ersten Hebelarms 6. Das Volumen des passiven Aktorelements 3 ist nun derart gewählt, daß die Längenausdehnung des passiven Aktorelements 3 die aus der Kippbewegung der ersten Platte 13 resultierende Längendifferenz ausgleicht. Es erfolgt bei Temperaturänderung keine mechanische Verspannung der ersten Platte 13 oder des ersten Hebelarms 6. Der Kopf 20 des Stellglieds 5 wird nicht bewegt. Der Arbeitspunkt der Vorrichtung 1 ändert sich bei Temperaturänderung nicht. Dies ermöglicht den Einsatz der Vorrichtung 1 insbesondere zur Ventilsteuerung, wobei ein geringer Nutzhub bei gleichzeitig definiertem Arbeitspunkt gefordert ist.

Bezeichnet - wie in Figur 2 dargestellt - $X_A$, $X_B$ und $X_C$ die Längenausdehnung des zweiten Hebelarms 8, die Längenausdehnung des passiven Aktorelements 3 bzw. die Längenausdehnung des aktiven Aktorelements 2, sowie a und b den Abstand des zweiten Hebelarms 8 vom passiven Aktorelement 3 bzw. den Abstand des passiven Aktorelements 3 vom aktiven Aktorelement 2, so muß gemäß den Hebelgesetzen die Vorrichtung 1 für den Fall, daß der Arbeitspunkt unbeeinflußt von der Temperatur bleibt, die Gleichung

$$\frac{X_A - X_B}{a+b} = \frac{X_B - X_C}{b}$$

erfüllen.

Figur 3 zeigt nun einen Querschnitt entlang der Linie A-A gemäß Figur 1. Deutlich ist der rechteckige Querschnitt sowohl des zweiten Hebelarms 8 als auch des gemeinsamen Stapels aus aktivem und passivem Aktorelement 2 und 3 zu erkennen. Zwischen den piezokeramischen Schichten des aktiven Aktorelements 2 sind jeweils Elektroden 26 eingelegt, die über die Kontaktierungsmittel 18 nach außen kontaktiert sind. Hierzu weist jede Elektrode 26 nach außen führende Laschen auf.

Figur 4 zeigt den gemeinsamen Stapel 27 aus aktivem und passivem Aktorelement 2 und 3 in einem Längsschnitt entlang der Linie B-B gemäß Figur 3. Man erkennt deutlich, auf welche Art und Weise die Elektroden 26 zwischen die einzelnen piezokeramischen Schichten 25 eingelegt sind. Die Elektroden 26 bestehen aus aufgedampten Silber. Da sich die Elektroden 26 nicht über den ganzen Querschnitt des gemeinsamen Stapels 27 erstrecken, entsteht ein aktives Aktorelement 2 und ein passives Aktorelement 3. Der Stapel 27 wird in einem einzigen Arbeitsgang hergestellt. Die einzelnen Schichten des Stapels 27 (d.h. die Elektroden 26 und die piezokeramischen Schichten 25) werden miteinander verklebt oder in sonstiger Art und Weise fest miteinander verbunden. Die Polarisation der Piezokeramik erfolgt durch Anlegen einer vorgegebenen Spannung an die Elektroden 26, so daß die Piezokeramik PI des passiven Aktorelements 3 unpolarisiert und damit inaktiv bleibt.

In Figur 5 ist eine zweite Vorrichtung 30 zur Betätigung eines Stellglieds 5 mit einem passiven und einem aktiven Aktorelement 2 bzw. 3 gezeigt. Das Stellglied 5 weist ein Schließglied 32 auf und ist über einen Ventilsitz 34 mit dem Gehäuse 15 verbunden. Die beiden Aktorelemente 2 und 3 sind als getrennte Piezostapel aufgebaut, die jedoch in identischer Weise hergestellt werden. Die Piezokeramik der Schichten des passiven Aktorelements 3 ist nicht polarisiert. Die beiden Aktorelemente 2 und 3 sind direkt mit dem Gehäuse 15 verbunden. Deutlich ist zwischen den beiden Aktorelementen 2 und 3 ein Zwischenspalt 35 zu erkennen.

Der erste Hebelarm 6 und der zweite Hebelarm 8 sind starr über ein Zwischenelement 36 miteinander verbunden. Anstelle eines gemeinsamen Lagers weist der zweite Hebelarm 8 eine kugelförmige Ausbuchtung auf, die den Kugelkopf 37 des Stellglieds 5 aufnimmt.

**Patentansprüche**

1. Vorrichtung (1,30) zum Betätigen eines Stellgliedes (5), mit einem aktiven Aktorelement (2) und einem passiven Aktorelement (3), die nebeneinander angeordnet sind, die durch Vorspannmittel (12) gemeinsam vorgespannt sind, und die mit einem Übertragungselement (4), welches für eine Wirkverbindung mit dem Stellglied (5) ausgebildet ist, kraftschlüssig verbunden sind, dadurch gekennzeichnet, daß das aktive und das passive Aktorelement (2,3) jeweils ein piezokeramisches Material (PI,PA) umfassen, wobei das piezokeramische Material (PI) des passiven Aktorelements (3) inaktiv ist.

2. Vorrichtung nach Anspruch 1, wobei das piezokeramische Material (PI) des passiven Aktorelements (3) unpolarisiert ist.

3. Vorrichtung nach Anspruch 1 oder 2, wobei das aktive Aktorelement (2) und das passive Aktorelement (3) jeweils als ein separater Stapel aus piezokeramischen Schichten aufgebaut sind, wobei zwischen zwei benachbarten piezokeramischen Schichten (25) jeweils eine Elektrode (26) eingelegt ist.

4. Vorrichtung nach Anspruch 1 oder 2, wobei ein gemeinsamer Stapel (27) aus piezokeramischen Schichten (25) vorgesehen ist, wobei zwischen zwei benachbarten piezokeramischen Schichten (25) jeweils eine Elektrode (26) eingelegt ist, wobei die Elektroden (26) jeweils übereinander angeordnet sind, und wobei sich die Elektroden (26) jeweils nur über einen Teil der Querschnittsfläche des Stapels (27) erstrecken.

5. Vorrichtung nach einem der vorhergehenden Ansprüche, wobei das passive Aktorelement (3) und das aktive Aktorelement (2) jeweils quaderförmig sind.

6. Vorrichtung nach einem der vorhergehenden Ansprüche, wobei unmittelbar dem passiven Aktorelement (3) benachbart an den Seitenflächen des aktiven Aktorelements Kontaktierungsmittel (18) angeordnet sind.

7. Vorrichtung nach einem der vorhergehenden Ansprüche, wobei das aktive Aktorelement (2) und das passive Aktorelement (3) in einem gemeinsamen Gehäuse (15) angeordnet sind, wobei eine Platte (13) beiden Aktorelementen (2,3) aufliegt und über die Vorspannmittel (12) mit dem Gehäuse (15) verbunden ist, und wobei die Vorspannmittel (12) im Bereich der Grenzfläche zwischen dem aktiven Aktorelement (2) und dem passiven Aktorelement (3) angeordnet sind.

8. Vorrichtung nach Anspruch 7, wobei das Übertragungselement (4) zwei Hebelarme (6,8) aufweist, wobei der erste Hebelarm (6) kraftschlüssig mit der Platte (13) verbunden ist, und wobei der zweite Hebelarm (8) für eine Wirkverbindung mit dem Stellglied (5) ausgebildet ist.

9. Vorrichtung nach Anspruch 7, wobei der erste und der zweite Hebelarm (6,8) zueinander schwenkbar gelagert sind.

10. Vorrichtung nach Anspruch 8 oder 9, wobei das Verhältnis der thermischen Ausdehnungskoeffizienten des passiven Aktorelements (3) und des aktiven Aktorelements (2) oder der Abstand des passiven Aktorelements (3) vom aktiven Aktorelement (2) nach den Hebelgesetzen derart eingestellt ist, daß das Stellglied (5) unabhängig von der Temperatur in einer vorgegebenen Position verbleibt.

11. Vorrichtung nach Anspruch 10, wobei das Verhältnis der thermischen Ausdehnungskoeffizienten über das Verhältnis der Volumina des aktiven und des passiven Aktorelements
(2,3) eingestellt ist.

FIG 1

FIG 2

FIG 3

FIG 4

FIG 5